Europäisches Patentamt

(19) European Patent Office

Office européen des brevets

(11) Publication number: **0 084 177**
**B1**

(12) EUROPEAN PATENT SPECIFICATION

(45) Date of publication of patent specification: **18.05.88**

(51) Int. Cl.⁴: **H 01 L 27/02,** G 05 F 3/20

(21) Application number: **82112096.1**

(22) Date of filing: **29.12.82**

(54) A semiconductor device having a back-gate bias generator.

(30) Priority: **14.01.82 JP 4698/82**

(43) Date of publication of application:
**27.07.83 Bulletin 83/30**

(45) Publication of the grant of the patent:
**18.05.88 Bulletin 88/20**

(84) Designated Contracting States:
**DE FR GB**

(56) References cited:
**EP-A-0 014 310**
**EP-A-0 023 782**
**EP-A-0 062 894**
**FR-A-2 200 634**

(73) Proprietor: **KABUSHIKI KAISHA TOSHIBA**
**72, Horikawa-cho Saiwai-ku**
**Kawasaki-shi Kanagawa-ken 210 (JP)**

(72) Inventor: **Nozawa, Hiroshi**
**105-1-604, Minesawa-cho Hodogaya-ku**
**Yokohama-shi (JP)**

(74) Representative: **Lehn, Werner, Dipl.-Ing. et al**
**Hoffmann, Eitle & Partner Patentanwälte**
**Arabellastrasse 4**
**D-8000 München 81 (DE)**

## Description

The present invention relates to a semiconductor device comprising a semiconductor region of one conductivity type which is an isolated region formed in the surface of a semiconductor substrate of an opposite conductivity type and a back-gate bias generating circuit for applying a back-gate bias voltage to the semiconductor region and including an oscillating circuit and a charge pump circuit, the latter being formed in the semiconductor region. Such a device is known from FR—A—2 200 634.

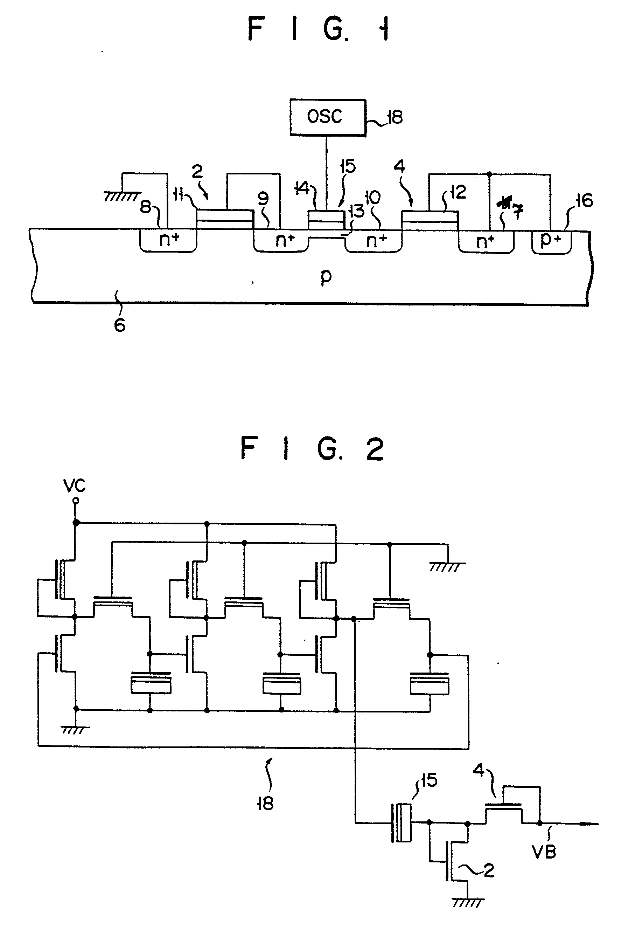

In the substrate bias generator, as shown in Fig. 1, a charge pumping circuit is comprised of n-channel MOS transistors 2, 4 and an MOS capacitor 15 formed in a P-type substrate 6 to which a back-gate bias voltage is to be applied. The transistor 2 is comprised of $n^+$-type regions 8 and 9 formed in the surface area of the P-type substrate 6 and a gate electrode layer 11 formed insulatively on that part of the substrate which lies between the $n^+$-type regions 8 and 9.

The MOS transistor 4 is formed of an $n^+$-type region 10 and an $n^+$-type region 7 formed in the surface area of the substrate 6 and a gate electrode layer 12 formed insulatively on that part of the substrate 6 which lies between the $n^+$-type regions 10 and 7.

The $n^+$-type regions 8 and 9 operate as source and drain of the MOS transistor 2, respectively, and the $n^+$-type regions 10 and 7 operate as source and drain of the MOS transistor 4, respectively. Further, the $n^+$-type regions 9 and 10 are electrically connected with each other through an $n^+$-type layer 13 formed in the surface area of the substrate 6. On this $n^+$-type layer 13 an electrode layer 14 is insulatively formed, and by this $n^+$-type layer 13 and the electrode layer 14 the MOS capacitor 15 is formed.

The $n^+$-type region 8 is grounded, and the $n^+$-type region 9 is connected to the gate electrode layer 11. The $n^+$-type region 7 and the gate electrode layer 12 are connected to a $p^+$-type region 16 formed in the surface area of the substrate 6, and the electrode layer 14 is connected to an oscillating circuit 18. In other areas of the substrate 6 there are formed semiconductor elements such as logic circuit elements, memory elements, etc. (not shown in the drawings).

In Fig. 2 there is shown a substrate bias generating circuit comprised of the semiconductor device and the oscillating circuit shown in Fig. 1. As shown in Fig. 2, the oscillating circuit 18 is a ring oscillator composed of three stages of inverter circuits, each of which includes an enhancement/depletion type MOS inverter and a CR delay circuit. The output signal of this oscillator 18 is generated from an output terminal of a CMOS inverter at a certain stage of the inverter circuit and supplied to one terminal of the MOS capacitor 15. The other terminal of the MOS capacitor 15 is grounded through the MOS transistor 2 and it is further connected to the substrate through the MOS transistor 4.

In a case where the substrate bias generating circuit shown in Fig. 2 is formed in the same substrate together with the memory circuit or the logic circuit, when the memory circuit or the logic circuit is operating, a leakage current IL1 begins to flow. In this case, a current IB1 is supplied from the ring oscillator 18 to the substrate through the MOS transistor 4. In this case if the total capacitance of the stray capacitor and junction capacitor associated with the substrate 6 is termed as CB1, a back-gate bias voltage VB1 is given by the following equation:

$$VB1 = (IB1 - IL1)/CB1$$

Here, in the case of the semiconductor device shown in Fig. 1 being accommodated in a package, there is a possibility that a leakage current path may be formed through the mount members and the package of the semiconductor, and the stray capacitance associated with the substrate may be largely affected by the presence of this package.

As a result, the leakage current IL1 may increase and/or the capacitance CB1 associated with substrate 6 may fluctuate, and accordingly, it becomes very difficult to obtain a desired back-gate bias voltage.

An object of the present invention is to provide a semiconductor device having a back-gate bias generator which generates a stable back-gate bias voltage.

This object has been achieved by providing a semiconductor device of the aforementioned type characterized in that the semiconductor region is a well region isolated from mount members and package by the substrate connected to a power supply Vc such that leakage currents are much smaller than leakage currents without the well region, stray capacitance is negligible when compared to that of the junction between the well region and the said substrate and so that the back-gate bias voltage can be set to a predetermined value in accordance with the impurity concentration of the substrate, and the oscillating circuit is formed in the semiconductor substrate or in the well region.

Accordingly, the capacitance associated with the semiconductor substrate will not be influenced by any external conditions and can be easily designed to have a desired value. Thus, the back-gate bias voltage can be easily set to a predetermined value.

This invention can be more fully understood from the following detailed description when taken in conjunction with the accompanying drawings, in which:

Fig. 1 is a schematic view of a model showing a semiconductor device having a conventional substrate bias generator;

Fig. 2 is a circuit diagram of the substrate bias generator shown in Fig. 1;

Fig. 3 is a schematic view of a model showing one embodiment of a semiconductor device having a back-gate bias generator according to the present invention; and

Fig. 4 is a schematic view of a model showing a modification of the semiconductor device shown in Fig. 3.

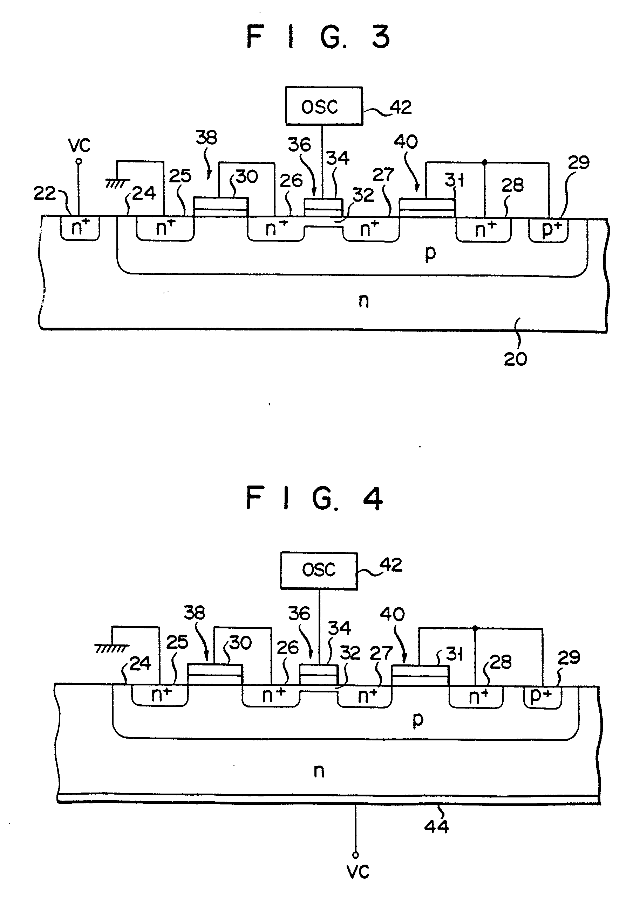

Fig. 3 shows a model of the semiconductor having a back-gate bias generator according to one embodiment of the present invention. This semiconductor device includes an $n^+$-type region 22 and a p-type isolated region or p-well region 24 formed in the surface area of an $n^+$-type substrate 20, $n^+$-type regions 25 to 28 and a $p^+$-type region 29 formed in the surface area of the p-well region 24.

Though not shown in the drawing, semiconductor elements, such as memory elements or logic circuit elements, for example, are formed in the p-well region 24.

On a substrate area between $n^+$-type regions 25 and 26 a gate electrode layer 30 is insulatively formed, and on a substrate area between $n^+$-type regions 27 and 28 a gate electrode layer 31 is also insulatively formed. The $n^+$-type regions 26 and 27 are formed in the surface area of the p-well region 24, and electrically connected to an $n^+$-type layer 32.

On this $n^+$-type layer 32 an electrode layer 34 is insulatively formed which, in combination with the $n^+$-type layer 32, constitutes an MOS capacitor 36. Further, the $n^+$-type regions 25 and 26 and the gate electrode layer 30 constitute an enhancement type n-channel MOS transistor 38, and the $n^+$-type regions 27, 28 and the gate electrode layer 31 constitute an enhancement type n-channel MOS transistor 40.

That is, the $n^+$-type regions 25 and 26 operate as source and drain regions of the MOS transistor 38, respectively, and the $n^+$-type regions 27 and 28 operate as source and drain regions of the MOS transistor 40, respectively.

A power supply terminal VC is connected to the $n^+$-type region 22, and the $n^+$-type region 25 is grounded. The $n^+$-type region 26 is connected to the gate electrode layer 30, and the $n^+$- and $p^+$-type regions 28 and 29 are connected to the gate electrode layer 31. The electrode layer 34 is connected to an oscillating circuit 42 which is the same as the oscillating circuit 18 shown in Fig. 1.

An equivalent circuit of this semiconductor device shown in Fig. 3 is substantially the same as that of the semiconductor device shown in Fig. 2, so that description with respect thereto is omitted. In this case, the MOS capacitor 36, the MOS transistors 38 and 40 and the oscillating circuit 42 correspond to the MOS capacitor 15, the MOS transistors 2 and 4 and the oscillating circuit 18, respectively.

When the oscillating circuit 42 is composed of n-channel MOS transistors, it is formed in the p-well region 24, and when the oscillating circuit 42 is composed of p-channel MOS transistors, it is formed outside the p-well region 24.

In the embodiment shown in Fig. 3, by means of the back-gate bias generator having the oscillating circuit 42 and the charge pump circuit, the back-gate bias voltage VB2 applied to the p-well region 24 is given by the following equation:

$$VB2 = (IB2 - IL2)/CB2$$

Here, a leakage current from the p-well region 24 is IL2, a capacitance associated with the p-well region 24 is CB2, and a current supplied to the p-well region 24 by the operation of the oscillating circuit 42 is IB2.

In the above-described case, the p-well region 24 is isolated from the mount members and the package by the substrate 20 to which a power supply (Vc) is connected, so that a leakage current path will not be formed between the p-well region 24 and the mount members or the package, and the leakage current is of a significantly smaller value as compared with that of the leakage current IL1 generated in the semiconductor device shown in Fig. 1.

Accordingly, it is possible to select a smaller value of supply current IB2, which results in the ability to reduce the size of MOS transistors which constitute the oscillating circuit 42.

The total capacitance associated with the p-well region 24 is largely dependent on the junction capacitor formed between the p-well region 24 and the substrate 20, that is, the stray capacitance which inevitably occurs between the mount members, the package and the p-well region 24 is sufficiently smaller so as to be negligible when compared with that of the above-mentioned junction capacitor.

The capacitance of the junction capacitor is changed in accordance with the impurity concentration of the substrate 20, so that the junction capacitance can be easily controlled. Consequently, the back-gate bias voltage VB2 can be easily set to a predetermined value, which results in the possibility of obtaining a stable back-gate bias voltage.

As above the present invention has been described with reference to one embodiment thereof, however, the present invention is not limited to this embodiment. For example, though it has been described heretofore that the oscillating circuit 42 is formed of the n-channel or p-channel MOS transistors, of course, it is possible to construct the oscillating circuit 42 with CMOS transistors. In this case the n-channel MOS transistors may be formed in the p-well region 24, and the p-channel MOS transistors may be formed outside the p-well region 24.

The power supply terminal VC is connected to the substrate 20 through the $n^+$-type region 22 in the above-described embodiment; however, as shown in Fig. 4, it may be also possible that a layer of aluminium 44, for example, is formed on the opposite surface of the substrate 20 to connect the power supply terminal VC to the aluminium layer 44.

Further, it may also be possible to form the $n^+$-type layer 32 of the same depth as those of the $n^+$-type regions 26 and 27.

**Claims**

1. A semiconductor device comprising a semiconductor region (24) of one conductivity type and a back-gate bias generating circuit for applying a back-gate bias voltage to said semiconductor region (24) and including an oscillating circuit section (42) and a charge pump circuit section (36, 38 and 40), said charge pump circuit being formed within said semiconductor region (24), said semiconductor region (24) being an isolated region formed in the surface area of said semiconductor substrate (20) of an opposite conductivity type, characterized in that:

said semiconductor region (24) is a well region isolated from mount members and package by said substrate (20) connected to a power supply (Vc) such that leakage currents are much smaller than leakage currents without said well region (24), stray capacitance is negligible when compared to that of the junction between the said well region (24) and the said substrate (20) and so that the back-gate bias voltage can be set to a predetermined value in accordance with the impurity concentration of said substrate (20), and

said oscillating circuit (42) is formed in said semiconductor substrate (20) or in said well region.

2. A semiconductor device according to claim 1, characterized in that said charge pump circuit section comprises:

first, second third and fourth impurity regions (25, 26, 27 and 28) formed in the surface area of said isolated region (24);

a first electrode layer (30) formed insulatively on a portion of said isolated region which lies (24) between the first and the second impurity regions (25, 26);

a second electrode layer (31) formed insulatively on a portoin of said island region (24) which lies between the third and the fourth impurity regions (27, 28);

a fifth impurity region (32) of the one conductivity type formed in the surface area of said isolated region (24) to electrically connect the second and third impurity regions (26, 27); and

a third electrode layer (34) insulatively formed on the fifth impurity region (32);

the first and second impurity regions (25, 26) and the first electrode layer (30) constitute a first MOS transistor, the third and fourth impurity regions (27, 28) and the second electrode layer (31) constitute a second MOS transistor, and

the fifth impurity region and the third electrode layer (34) constitute an MOS capacitor.

3. A semiconductor device according to claim 2, characterized by further comprising a sixth impurity region (29) of the opposite conductivity type which is electrically connected to the fourth impurity region (28) and the second electrode layer (31), and formed in the surface area of said isolated region (24) and having an impurity concentration higher than that of said isolated region.

4. A semiconductor device according to claim 2, characterized by further comprising a seventh impurity region (22) connected to the power supply (Vc) of the one conductivity type formed in the surface area of the semiconductor substrate (20) and having an impurity concentration higher than that of said semiconductor substrate (20).

5. A semiconductor device according to claim 2, characterized by further comprising a conductive layer (44) connected to the power supply (Vc) formed on the surface of said semiconductor substrate (20) opposing the surface in which said isolated region 24 is formed.

6. A semiconductor device according to claim 1, characterized in that said one conductivity type is the n-type.

**Patentansprüche**

1. Halbleitervorrichtung mit einem Halbleiterbereich (24) eines Leitfähigkeitstyps und einem eine Gatter-Sperrvorspannungs erzeugenden Kreis zum Anlegen einer Gatter-Sperrvorspannung an dem Halbleiterbereich (24) und mit einem Schwungkreisteil (42) und einem Ladungspumpen-Kreisteil (36, 38 und 40), wobei der Ladungspumpenkreis innerhalb des Halbleiterbereichs (24) ausgebildet ist und der Halbleiterbereich (24) ein getrennter Bereich ist, der in dem Oberflächenbereich des Halbleitersubstrats (20) eines entgegengesetzten Leitfähigkeitstyps ausgebildet ist, dadurch gekennzeichnet,

daß der Halbleiterbereich (24) ein Muldenbereich ist, der von Befestigungsteilen und Paket durch das an einer Spannungsquelle (Vc) angestoßene Substrat (20) derart getrennt ist, daß Leckströme wesentlich kleiner sind als Leckströme ohne den Muldenbereich (24), daß Streukapazitäten vernachlässigbar sind im Vergleich mit der der Verbindung zwischen dem Muldenbereich (24) und dem Substrat (20), und daß die Gatter-Sperrvorspannung auf einen vorbestimmten Wert entsprechend der Störstoffkonzentration des Substrats (20) eingestellt werden kann, und der Schwungkreis (42) in dem Halbleitersubstrate (20) oder in dem muldenbereich ausgebildet ist.

2. Halbleitervorrichtung nach Anspruch 1, dadurch gekennzeichnet, daß der Ladungspumpenkreisteil folgendes enthält:

erste, zweite und dritte Störstoffbereiche (25, 26, 27 und 28), die in dem Oberflächenbereich des getrennten Bereichs (24) ausgebildet sind;

eine erste Elektrodenschicht (30), die auf einem Teil des getrennten Bereichs (24) isolierend ausgebildet ist, der zwischen dem ersten und dem zweiten Störstoffbereich (25, 26) liegt;

eine zweite Elektrodenschicht (31), die auf einem Teil des Inselbereichs (24) ausgebildet ist, der zwischen dem dritten und vierten Störstoffbereich (27, 28) liegt;

einen fünften Störstoffbereich (32) des einen Leitfähigkeitstyps, der in dem Oberflächenbereich des getrennten Bereichs (24) ausgebildet ist, um den zweiten und dritten Störstoffbereich (26, 27) elektrisch zu verbinden; und

eine dritte Elektrodenschicht (24), die auf dem fünften Störstoffbereich (32) isolierend ausgebildet ist,

der erste und zweite Störstoffbereich (25, 26) und die erste Elektrodenschicht (30) einen ersten MOS-Transistor, der dritte und vierte Störstoffbereich (27, 28) einen zweiten MOS-Transistor bilden, und

der fünfte Störstoffbereich und die dritte Elektrodenschicht (34) einen MOS-Kondensator bilden.

3. Halbleitervorrichtung nach Anspruch 2, gekennzeichnet durch einen sechsten Störstoffbereich (29) des entgegengesetzten Leitfähigkeitstyps, der mit dem vierten Störstoffbereich (28) und der zweiten Elektrodenschicht (31) elektrisch verbunden ist, und der in dem Oberflächenbereich des getrennten Bereiches (24) ausgebildet ist und eine Störstoffkonzentration, größer als die des getrennten Bereichs aufweist.

4. Halbleitervorrichtung nach Anspruch 2, gekennzeichnet durch einen siebten mit der Spannungsquelle (Vc) verbundenen Störstoffbereich (22) des einen Leitfähigkeitstyps, der in einem Oberflächenbereich des Halbleitersubstrats (20) ausgebildet ist und eine Störstoffkonzentration, größer als die des Halbleitersubstrats (20) aufweist.

5. Halbleitervorrichtung nach Anspruch 2, gekennzeichnet durch eine an der Spannungsquelle (Vc) angeschlossene leitfähige Schicht (44), die auf der Oberfläche des Halbleitersubstrats (20), gegenüber der Oberfläche ausgebildet ist, in welcher der getrennte Bereich (24) ausgebildet ist.

6. Halbleitervorrichtung nach Anspruch 1, dadurch gekennzeichnet, daß der eine Leitfähigkeitstyp ein n-Typ ist.

**Revendications**

1. Composant à semi-conducteur comportant une région semi-conductrice (24) d'un type de conductivité et un circuit générateur de contre-polarisation de grille destiné à appliquer une tension de contre-polarisation de grille à ladite région semi-conductrice (24) et comprenant une section de circuit oscillateur (42) et une section de circuit de pompage de charge (36, 38 et 40), ledit circuit de pompage de charge étant formé dans ladite région semi-conductrice (24), ladite région semi-conductrice (24) étant une région isolée formée dans la région de surface dudit substrate semi-conducteur (20) d'un type de conductivité opposé, caractérisé en ce que:

ladite région semi-conductrice (24) est une région de puits isolée des pièces de montage et du boîtier par ledit substrat (20) connecté à une source d'alimentation (Vc) de manière que les courants de fuite soient très inférieurs aux courants de fuite en l'absence de ladite région de puits (24), la capacité parasite étant négligeable comparée à celle de la jonction entre ladite région de puits (24) et ledit substrat (20) et de manière que la tension de contre-polarisation de grille puisse être réglée à une valeur prédéterminée en fonction de la concentration des impuretés dudit substrat (20), et ledit circuit oscillateur (42) est formé dans ledit substrat semi-conducteur (20) ou dans ladite région de puits.

2. Composant à semi-conducteur selon la revendication 1, caractérisé en ce que ladite section de circuit de pompage comporte:

une première, une seconde, une troisième et une région d'impuretés (25, 26, 27 et 28) formées dans la région de surface de ladite région isolée (24);

une première couche d'électrode (30) formée en étant isolée sur une partie de ladite région isolée qui se situe (24) entre la première et la seconde région d'impuretés (25, 26);

une seconde couche d'électrodes (31) formée en étant isolée sur une partie de ladite région d'ilot (24) qui se situe entre le troisième et la quatrième région d'impuretés (27, 28);

une cinquième région d'impuretés (32) du premier type de conductivité, formée sur la région de surface de ladite région isolée (24) pour connecter électriquement la seconde et la troisième région d'impuretés (26, 27), et

une troisième couche d'électrodes (34) formée en en étant isolée sur la cinquième région d'impuretés (32),

la première et la seconde région d'impuretés (25, 26) et la première couche d'électrodes (30) constituant un premier transistor MOS, la troisième et la quatrième région d'impuretés (27, 28) et la seconde couche d'électrodes (31) constituant un second transistor MOS, et

la cinquième région d'impuretés et la troisième couche d'électrodes (34) constituant un condensateur MOS.

3. Composant à semi-conducteur selon la revendication 2, caractérisé en ce qu'il comporte en outre une sixième région d'impuretés (29) du type de conductivité opposé qui est connectée électriquement à la quatrième région d'impuretés (28) et à la seconde couche d'électrodes (31) et formée dans la région de surface de ladite région isolée (24) et ayant une concentration d'impuretés supérieure à celle de ladite région isolée.

4. Composant à semi-conducteur selon la revendication 2, caractérisé en ce qu'il comporte en outre une septième région d'impuretés (22) connectée à la source d'alimentation (Vc) d'un type de conductivité, formée dans la région de surface du substrat semi-conducteur (20) et ayant une concentration d'impuretés supérieure à celle dudit substrat semi-conducteur (20).

5. Composant à semi-conducteur selon la revendication 2, caractérisé en ce qu'il comporte en outre une couche conductrice (44) connectée à la source d'alimentation (Vc), formée sur la surface dudit substrat semiconducteur (20) opposée à la surface dans laquelle est formée ladite région isolée (24).

6. Composant à semi-conducteur selon la revendication 1, caractérisé en ce que ledit premier type de conductivité est le type N.

# F I G. 1

# F I G. 2

# F I G. 3

OSC ~42

VC

38  36  34  40
30  26  32  27  31  28  29
22  24  25

OSC

n⁺  n⁺  n⁺  n⁺  n⁺  p⁺

p

n

20

# F I G. 4

OSC ~42

38  36  34  40
30  26  32  27  31  28  29
24  25

n⁺  n⁺  n⁺  n⁺  p⁺

p

n

44

VC